# EUROPÄISCHE PATENTSCHRIFT

(11) **EP 1 256 974 B1**
(45) Veröffentlichungstag und Bekanntmachung des Hinweises auf die Patenterteilung: **19.05.2004**
(21) Anmeldenummer: 01810444.8
(22) Anmeldetag: 07.05.2001
(51) Int. Cl.: H01L 21/00, H05K 13/04

(54) **Montageautomat für die Plazierung eines Halbleiterchips als Flipchip auf einem Substrat**
Apparatus for placing a semiconductor chip as a flip chip on a substrate
Dispositif pour le placement d'une puce semiconductrice telle qu' une flip-chip sur un substrat

(43) Veröffentlichungstag der Anmeldung: 13.11.2002
(73) Patentinhaber: Esec Trading S.A., 6330 Cham (CH)
(72) Erfinder: Grueter, Ruedi, 6206 Neuenkirch (CH); Hartmann, Dominik, 6332 Hagendorn (CH)
(74) Vertreter: Falk, Urs, Dr.

(56) Entgegenhaltungen:
- EP-A- 0 772 229
- US-A- 5 839 187
- PATENT ABSTRACTS OF JAPAN vol. 015, no. 157 (E-1058), 19. April 1991 (1991-04-19) & JP 03 029334 A (MATSUSHITA ELECTRIC IND CO LTD), 7. Februar 1991 (1991-02-07)

## Beschreibung

Die Erfindung betrifft einen Montageautomaten der im Oberbegriff des Anspruchs 1 genannten Art für die Plazierung eines Halbleiterchips als Flipchip auf einem Substrat.

Für die Montage von Flipchips sind zwei Arten von Maschinen auf dem Markt erhältlich, nämlich sogenannte Pick and Place Maschinen, die eine sehr genaue Positionierung der Flipchips auf dem Substrat gewährleisten, aber vergleichsweise langsam sind, und sogenannte Die Bonder, die einen höheren Durchsatz, aber geringere Genauigkeit erreichen. Beiden Maschinentypen ist gemeinsam, dass der zu flippende Chip zunächst mit einer als Flipper bezeichneten Vorrichtung einem auf eine Folie aufgespannten und expandierten Wafer entnommen, geflippt und dann vom Pick and Place System zum Substrat transportiert und darauf plaziert wird. US 5 839 187 beschreibt eine Flipchip-Vorrichtung für Hableiterchips mit einem Pick und Place Mechanisms.

Der Erfindung liegt die Aufgabe zugrunde, eine Vorrichtung für die Montage von Flipchips zu entwickeln, die Flipchips schnell und mit höchster Präzision auf dem Substrat plaziert.

Die genannte Aufgabe wird erfindungsgemäss gelöst durch die Merkmale des Anspruchs 1.

Ausgangspunkt der Erfindung ist ein als Die Bonder bekannter Montageautomat, wie er beispielsweise in der europäischen Patentanmeldung EP 923 111 beschrieben und von der Anmelderin unter der Bezeichung DB 2008 vertrieben wird. Die Halbleiterchips haften auf einer auf einem Waferring eingespannten und expandierbaren Folie. Der Waferring wird durch einen Wafertisch in zwei orthogonalen Richtungen positioniert. Bei diesem Die Bonder werden die Halbleiterchips vom Wafertisch an einem vorbestimmten Ort A bereitgestellt, von einem Pick und Place System mit einem mit hoher Geschwindigkeit hin und her fahrenden Bondkopf ergriffen und an einem vorbestimmten Ort B auf dem Substrat abgesetzt. Gemäss der Erfindung ist nun vorgesehen, einen derartigen Die Bonder um eine Flip-Vorrichtung zum Flippen des Halbleiterchips zu erweitern. Die Flip-Vorrichtung übernimmt den Halbleiterchip am Ort B vom Bondkopf, transportiert den Halbleiterchip zu einem Ort C, flippt den Halbleiterchip während des Transports vom Ort B zum Ort C, und setzt den Halbleiterchip am Ort C als Flipchip auf dem Substrat ab. Die Flip-Vorrichtung ist als Parallelogrammkonstruktion ausgebildet.

Nachfolgend wird ein Ausführungsbeispiel der Flip-Vorrichtung anhand der Zeichnung näher erläutert.

Es zeigen:
- Fig. 1: einen Die Bonder mit einer Flip-Vorrichtung zum Flippen eines Halbleiterchips,
- Fig. 2: die Flip-Vorrichtung im Detail,
- Fig. 3A-C: die Flip-Vorrichtung in verschiedenen Zuständen,
- Fig. 4, 5: eine weitere Flip-Vorrichtung mit einer Krafteinheit, und
- Fig. 6: die Krafteinheit.

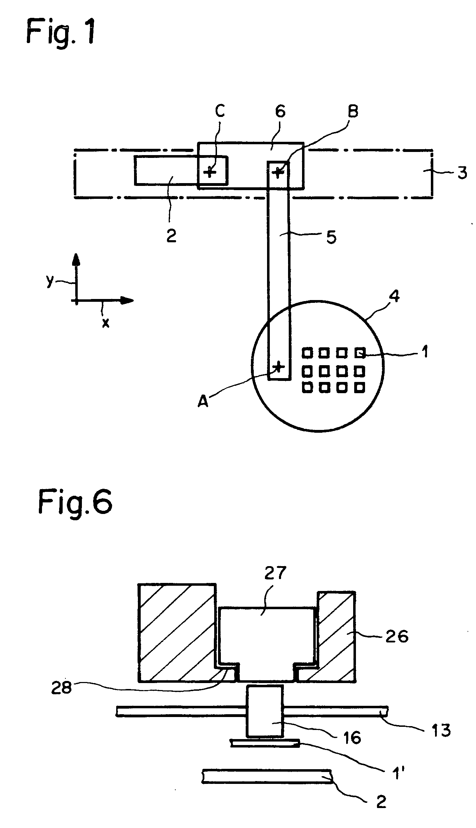

Die Fig. 1 zeigt schematisch und in Aufsicht einen Die Bonder für die Plazierung von Halbleiterchips 1 auf einem Substrat 2. Mit x, y und z sind die drei Koordinatenachsen eines kartesischen Koordinatensystems bezeichnet, wobei die z-Achse der vertikalen Richtung entspricht. Der Die Bonder umfasst ein Transportsystem 3 für den Transport des Substrats in x-Richtung und, fakultativ, auch in y-Richtung. Ein geeignetes Transportsystem 3 ist z.B. im europäischen Patent EP 330 831 beschrieben. Die Halbleiterchips 1 werden vorzugsweise auf einem Wafertisch 4 nacheinander an einem Ort A bereitgestellt. Ein Pick and Place System 5, beispielsweise das in der europäischen Patentanmeldung EP 923 111 beschriebene Pick and Place System, entnimmt den Halbleiterchip 1 am Ort A und transportiert ihn zu einem Ort B über dem Substrat 2, wo es den Halbleiterchip 1 an eine Flip-Vorrichtung 6 übergibt. Die Flip-Vorrichtung 6 dreht den Halbleiterchip 1 um 180° und plaziert ihn als Flipchip an einem Ort C auf dem Substrat 2. Bevorzugt ist die Flip-Vorrichtung 6 so ausgebildet, dass ein allfälliger Lagefehler des zu plazierenden Halbleiterchips 1 während des Transports vom Ort B zum Ort C auskorrigiert werden kann.

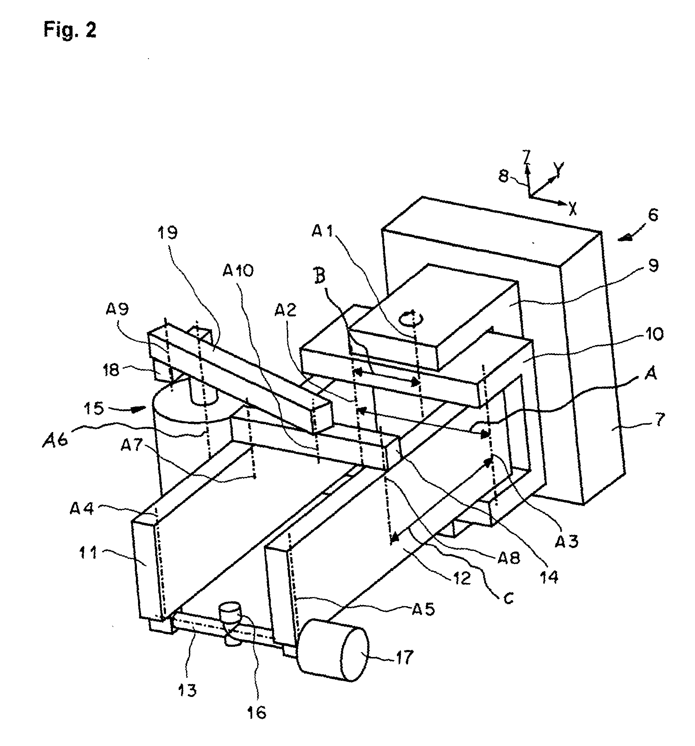

Die Fig. 2 zeigt im Detail und in perspektivischer Darstellung die Flip-Vorrichtung 6. Die Flip-Vorrichtung 6 umfasst einen ortsfest angeordneten Träger 7, einen am Träger 7 in vertikaler Richtung 8 bewegbaren Schlitten 9, einen am Schlitten 9 gelagerten, um eine vertikale Achse A1 drehbaren Tragkörper 10, zwei gleiche, am Tragkörper 10 gelagerte Schwenkarme 11 und 12, einen ersten und einen zweiten Verbindungsarm 13 bzw. 14, die die beiden Schwenkarme 11, 12 2 verbinden, ein Antriebssystem 15 5 zum Schwenken der beiden Schwenkarme 11, 12, einen auf dem ersten Verbindungsarm 13 angebrachten Chipgreifer 16 und einen Antrieb 17 zum Drehen des ersten Verbindungsarmes 13 um seine Längsachse und damit des Chipgreifers 16 um 180°.

Der Tragkörper 10 weist zwei vertikale, im Abstand A angeordnete Lagerachsen A2 und A3 auf, die je ein Ende des ersten Schwenkarmes 11 bzw. des zweiten Schwenkarmes 12 lagern. Der erste Verbindungsarm 13 weist ebenfalls zwei vertikale, im Abstand A angeordnete Lagerachsen A4 und A5 auf, die das andere Ende des ersten Schwenkarmes 11 bzw. des zweiten Schwenkarmes 12 lagern. Der Tragkörper 10, die beiden Schwenkarme 11 und 12 und der erste Verbindungsarm 13 bilden eine Parallelogrammkonstruktion.

Das Antriebssystem 15 besteht im wesentlichen aus einer um eine vertikale Achse A6 drehbaren Kurbel 18 und einer Antriebsstange 19, deren eines Ende am äusseren Ende der Kurbel 18 und deren anderes Ende am zweiten Verbindungsarm 14 gelagert ist. Das eine Ende des zweiten Verbindungsarms 14 ist am Schwenkarm 11 1 in einer vertikal verlaufenden Achse A7, das andere Ende des zweiten Verbindungsarms 14 ist am Schwenkarm 12 in einer vertikal verlaufenden Achse A8 gelagert. Die Lagerachsen der Antriebsstange 19 verlaufen ebenfalls vertikal und sind mit den Bezugszeichen A9 und A10 0 bezeichnet. Die Lagerachse A1 verläuft im Abstand B zur Lagerachse A2. Die Lagerachse A10 verläuft im Abstand B zur Lagerachse A7. Der Chipgreifer 16 ist im Abstand B zur Lagerachse A4 auf dem ersten Verbindungsarm 13 angeordnet. Die Lagerachsen A1, A10 und der Chipgreifer 16 befinden sich somit auf einer parallel zu den Schwenkarmen 11 und 12 verlaufenden Geraden. Die Lagerachsen A7 und A8 sind im Abstand C zur Lagerachse A2 bzw. A3 angeordnet, so dass der zweite Verbindungsarm 14 parallel zum Tragkörper 10 und parallel zum ersten Verbindungsarm 13 ausgerichtet ist. Der Nutzen der Parallelogrammkonstruktion liegt darin, dass der erste Verbindungsarm 13 immer parallel zum Tragkörper 10 ausgerichtet bleibt. Auf diese Weise kann ein allfälliger Lagefehler des Halbleiterchips 1 über eine Korrekturbewegung des Tragkörpers 10 vollständig eliminiert werden.

Das Antriebssystem 15 dient der Hin- und Herbewegung des Chipgreifers 16 zwischen einer ersten und einer zweiten Endlage, die bevorzugt mechanisch durch Strecklagen der Kurbel 18 8 und der Antriebsstange 19 definiert sind. Strecklage bedeutet, dass die Kurbel 18 und die Antriebsstange 19 in die gleiche Richtung zeigen, d.h. dass die Lagerachsen A6, A9 und A10 auf einer Geraden liegen. Dies hat den Vorteil, dass sich ein allfälliger Lagefehler des Antriebssystems 15 praktisch nicht auf die Lage des Chipgreifers 16 auswirkt.

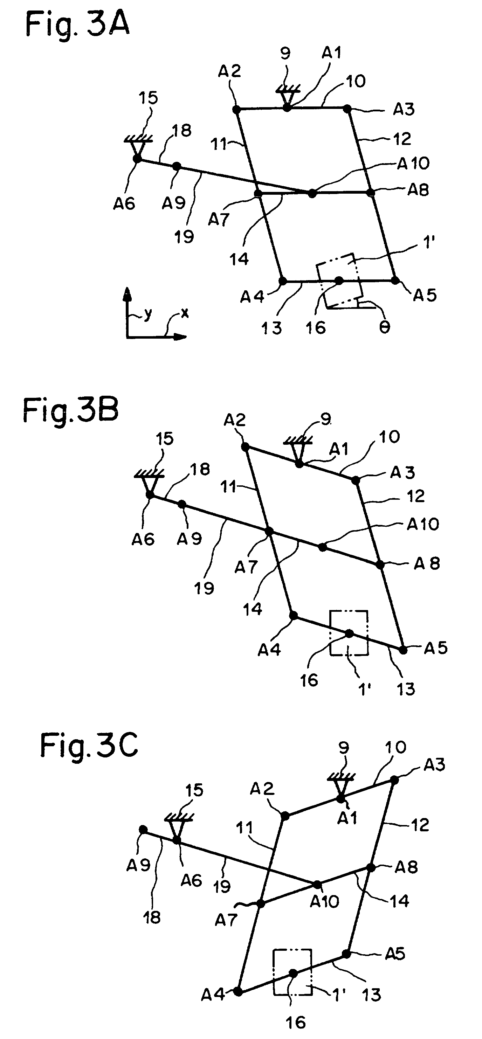

Die Fig. 3A zeigt schematisch und in Aufsicht die Parallelogrammkonstruktion, die sich in der ersten Endlage befindet. Der Tragkörper 10 ist zudem parallel zur x-Achse ausgerichtet. In dieser Lage wird der von einem Pick and Place System 5 (Fig. 1) transportierte Halbleiterchip 1', dessen Oberseite Bumps aufweist, an die Flip-Vorrichtung übergeben, d.h. der Halbleiterchip l'wird von einem Bondkopf des Pick and Place Systems 5 auf dem nach oben gerichteten Chipgreifer 16 abgesetzt und dort vorzugsweise mittels Vakuum festgehalten. Die Bumps des Halbleiterchips l'zeigen dabei nach oben. Nach diesem Schritt ist der in der Fig. 3A dargestellte Halbleiterchip l'möglicherweise gegenüber seiner Soll-Lage auf dem Substrat um den Vektor Δx, Δy verschoben und um den Winkel Δθ gegenüber der x-Achse verdreht. Der durch den Winkel Δθ charakterisierte Winkelfehler des Halbleiterchips 1' kann durch Drehen des Tragkörpers 10 um die Drehachse A1 auskorrigiert werden. Dabei dient die Achse A10 als Referenz. Die Fig. 3B zeigt die Parallelogrammkonstruktion in diesem Zustand, wo der Tragkörper 10 gegenüber seiner ursprünglichen Lage um den Winkel -Δθ verdreht ist. Der Halbleiterchip 1' ist nun parallel zur x-Richtung ausgerichtet. Die Richtung der Schwenkarme 11, 12 ist vorerst noch unverändert. Der durch den Vektor Δx, Δy charakterisierte Lagefehler des Halbleiterchips 1' kann beispielsweise durch eine Korrekturbewegung des Substrates in x- und in y-Richtung eliminiert werden. Eine andere Möglichkeit besteht darin, den Schlitten 9 derart am Träger 7 zu lagern, dass er neben der vertikalen Bewegung auch Bewegungen in x- und in y-Richtung ausführen kann. Dazu sind beispielsweise zwei Mikromanipulatoren vorgesehen, die eine Bewegung des Schlittens 9 gegenüber dem Träger 7 in x- bzw. in y-Richtung um typisch einige 10 bis einige 100 µm ermöglichen. Diese Korrekturbewegungen erfolgen, bevor der Chipgreifer 16 den Halbleiterchip l'auf dem Substrat 2 (Fig. 1) absetzt.

Das Antriebssystem 15 bringt nun die Parallelogrammkonstruktion in die zweite Endlage, indem die Kurbel 18 um einen entsprechend den gewählten geometrischen Verhältnissen bestimmten Winkel gedreht wird, bis sich die Kurbel 18 und die Antriebsstange 19 in der zweiten Strecklage befinden. Diese zweite Endlage ist in der Fig. 3C dargestellt. Bei dieser Bewegung der Parallelogrammkonstruktion ändert die Orientierung des Halbleiterchips 1' nicht.

Alternativ zu dem mit zwei Strecklagen arbeitenden Antriebssystem 15 könnte ein elastisches Antriebssystem verwendet werden, das die Parallelogrammkonstruktion in der ersten Endlage an einem ersten Anschlag und in der zweiten Endlage an einem zweiten Anschlag zum Anschlag bringt. Die Antriebskraft muss aber über die Achse A10 eingeleitet werden, da die Achse A10 als Referenz für die Korrektur des allfälligen Winkelfehlers Δθ erforderlich ist.

Während der Verschiebung der Parallelogrammkonstruktion von ihrer ersten Endlage in ihre zweite Endlage laufen verschiedene Bewegungen parallel dazu ab:
a) Der Chipgreifer 16 wird vom Antrieb 17 um 180° gedreht, so dass die Bumps des Halbleiterchips 1' nun nach unten zeigen.
b) Der Schlitten 9 wird in vertikaler Richtung 8 angehoben und wieder abgesenkt, um zu vermeiden, dass der mit dem Chipgreifer 16 drehende Halbleiterchip 1' das Substrat berührt.
c) Ein allfälliger Winkelfehler des Halbleiterchips 1 wird durch Drehen des Tragkörpers 10 auskorrigiert. Die Drehbewegung des Tragkörpers 10 wird dabei offsetfrei auf den Halbleiterchip 1' übertragen.
d) Ein allfälliger Lagefehler des Halbleiterchips l'wird durch entsprechende Korrekturbewegungen entweder des Schlittens 9 mittels der Mikromanipulatoren oder des Substrats 2 auskorrigiert.

Sobald die Parallelogrammkonstruktion ihre zweite Endlage erreicht hat, wird der Schlitten 9 auf eine vorbestimmte Höhe H über dem Substrat 2, bzw. über einer Auflageplatte, auf der das Substrat 2 aufliegt, abgesenkt. Sobald der Halbleiterchip auf dem Substrat 2 auftrifft, wird der Chipgreifer 16 gegenüber dem Schlitten 9 entgegen der Kraft einer Feder ausgelenkt. Die Höhe H ist so eingestellt, dass der Halbleiterchip mit einer vorbestimmten Bondkraft gegen das Substrat 2 (Fig. 1) gedrückt wird. (Dieses Verfahren ist allgemein als Overtravel-Verfahren bekannt.)

Bei diesem ersten Ausführungsbeispiel erfolgt die Erfassung der Lage des Halbleiterchips 1 (Fig. 1) mittels einer ersten, über dem Ort A angebrachten Kamera, nachdem er vom Wafertisch am Ort A bereitgestellt wurde, d.h. unmittelbar vor dem Picken am Ort A. Mittels einer zweiten Kamera wird auch das Substrat 2 am Ort C vermessen. Aus diesen Daten wird eine allfällige Abweichung der Ist-Lage des Halbleiterchips von seiner Soll-Lage auf dem Substrat 2 berechnet und wie oben dargelegt vor dem Absetzen am Ort C korrigiert.

Zur Erhöhung der Plazierungsgenauigkeit ist bei einem weiteren Ausführungsbeispiel vorgesehen, eine Kamera über dem Ort B zu montieren, so dass sich der Chipgreifer 16 im Blickfeld der Kamera befindet, und die Lage des Halbleiterchips l'erst dann zu vermessen, wenn der Halbleiterchip l'vom Chipgreifer 16 der Flip-Vorrichtung gehalten ist. Diese Lösung hat den Vorteil, dass der Halbleiterchip l'in der Lage vermessen wird, in der er vom Chipgreifer 16 auf dem Substrat 2 plaziert wird.

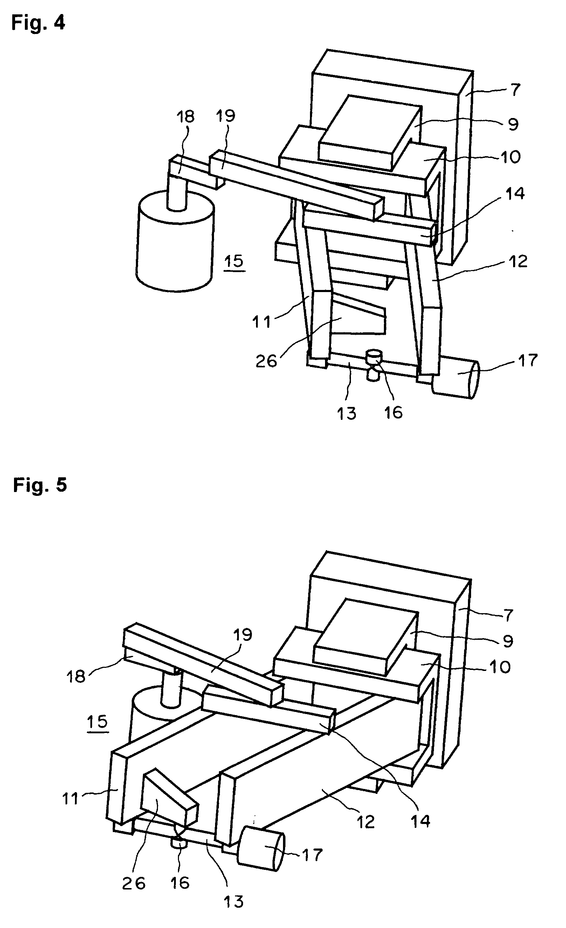

Bei der Plazierung des Halbleiterchips l'auf dem Substrat ist bei gewissen Anwendungen eine vergleichsweise hohe Bondkraft erforderlich. Es kann vorteilhaft sein, diese Bondkraft nicht vom Schlitten 9 her über die Schwenkarme 11, 12 auf den Chipgreifer 16 zu übertragen, sondern, wie in den Fig. 4 und 5 gezeigt, mittels einer starr am ersten Schwenkarm 11 angeordneten Krafteinheit 26. Die Fig. 4 zeigt die Flip-Vorrichtung in der ersten Endlage, in der der Chipgreifer 16 zur Aufnahme des nächsten Halbleiterchips bereit ist. In dieser Endlage befindet sich die Krafteinheit 26 hinter dem Chipgreifer 16, so dass der Halbleiterchip vom Pick and Place System 5 (Fig. 1) problemlos auf den Chipgreifer 16 abgesetzt werden kann. Die Fig. 5 zeigt die Flip-Vorrichtung in der zweiten Endlage, in der der nun geflippte Halbleiterchip auf dem Substrat 2 (Fig. 1) plaziert wird. Beim Schwenken des ersten Schwenkarms 11 hat sich die Lage der Krafteinheit 26 relativ zur Lage des Chipgreifers 16 derart geändert, dass sich die Krafteinheit 26 nun direkt oberhalb des Chipgreifers 16 befindet. Die Krafteinheit 26 weist einen in vertikaler Richtung bewegbaren Kolben auf, der beispielsweise pneumatisch, hydraulisch oder elektromechanisch angetrieben wird. Das Plazieren des Halbleiterchips auf dem Substrat soll mit einer vorbestimmten Bondkraft erfolgen, die bei bestimmten Anwendungen relativ gross sein kann. Zu diesem Zweck wird der Kolben der Krafteinheit 26 abgesenkt, so dass er den Chipgreifer 16 mit der vorbestimmten Bondkraft gegen das Substrat 2 drückt.

Bei einer bevorzugten, in der Fig. 6 schematisch dargestellten Ausführung ist der Kolben ein mit einem vorbestimmten Druck beaufschlagter Druckzylinder 27, der in der Ruhelage auf einem Anschlag 28 der Krafteinheit 26 aufliegt. Zum Aufbau der Bondkraft wirkt die Krafteinheit 26 wie folgt mit dem Chipgreifer 16 zusammen: Wie bereits erwähnt, befindet sich die Krafteinheit 26 in der zweiten Endlage der Parallelogrammkonstruktion oberhalb des Chipgreifers 16. Zum Plazieren des Halbleiterchips wird der Schlitten 9, wie weiter oben erwähnt, auf eine vorbestimmte Höhe H abgesenkt. Sobald der Halbleiterchip auf dem Substrat 2 (Fig. 1) auftrifft, baut sich zwischen dem Substrat 2 und dem Halbleiterchip eine Kraft auf, die dazu führt, dass der Chipgreifer 16 nach oben ausgelenkt wird. Das obere Ende des Chipgreifers 16 kommt dabei am Druckzylinder 27 zum Anschlag. Die Höhe H ist so vorbestimmt, dass der Druckzylinder 27 gegenüber der Krafteinheit 26 in jedem Fall ausgelenkt wird, so dass die Kraft, mit der der Halbleiterchip auf das Substrat 2 gedrückt wird, der vorbestimmten Bondkraft entspricht. Der Vorteil dieses Ausführungsbeispiels liegt darin, dass die Bondkraft unabhängig von Dickenschwankungen des Substrats 2 ist.

Die aus dem Tragkörper 10, dem ersten Schwenkarm 11, dem zweiten Schwenkarm 12 und dem Verbindungsarm 13 gebildete Parallelogrammkonstruktion ist wegen der Hin- und Her Bewegung der beiden Schwenkarme 11, 12 und wegen der Korrekturmöglichkeit für den Winkel Δθ um den zweiten Verbindungsarm 14 erweitert. Dies führt mechanisch zu einer Überbestimmung und macht eine ergiebige, d.h. etwas Spiel erlaubende, Lagerung des ersten Verbindungsarmes 13 oder des zweiten Verbindungsarmes 14 nötig. Bevorzugt ist der erste Verbindungsarm 13 bei der Lagerachse A5 ergiebig gelagert.

## Patentansprüche

1. Montageautomat für die Plazierung eines Halbleiterchips (1') als Flipchip auf einem Substrat (2), mit einer Flip-Vorrichtung (6) zum Flippen des Halbleiterchips (1'), **dadurch gekennzeichnet, dass** die Flip-Vorrichtung (6) als Parallelogrammkonstruktion (10, 11, 12, 13) ausgebildet ist, wobei die Parallelogrammkonstruktion (10, 11, 12, 13) aus einem Tragkörper (10), einem ersten und einem zweiten Schwenkarm (11, 12) und einem Verbindungsarm (13) besteht, und wobei am Verbindungsarm (13) ein Chipgreifer (16) angeordnet ist, und dass ein Antriebssystem (15, 18, 19) vorhanden ist für die Hin und Her Bewegung der Parallelogrammkonstruktion (10, 11, 12, 13) zwischen einer ersten Endlage, wo der Chipgreifer (16) den Halbleiterchip (1') annimmt, und einer zweiten Endlage, wo der Chipgreifer (16) den Halbleiterchip (1) auf dem Substrat (2) plaziert.

2. Montageautomat nach Anspruch 1, **dadurch gekennzeichnet, dass** die Parallelogrammkonstruktion (10, 11, 12, 13) an einem in vertikaler Richtung (8) bewegbaren Schlitten (9) angeordnet ist und dass der Tragkörper (10) gegenüber dem Schlitten (9) um eine vertikale Drehachse (A1) drehbar ist.

3. Montageautomat nach Anspruch 1 oder 2, **dadurch gekennzeichnet, dass** die erste Endlage und die zweite Endlage der Parallelogrammkonstruktion (10, 11, 12, 13) mechanisch durch Strecklagen des Antriebssystems (15, 18, 19) definiert sind.

4. Montageautomat nach einem der Ansprüche 1 bis 3, **dadurch gekennzeichnet, dass** am ersten Schwenkarm (11) eine Krafteinheit (26) angeordnet ist, die zur Erzeugung der beim Plazieren zwischen dem Halbleiterchip (1) und dem Substrat (2) aufzubringenden Kraft dient.

5. Montageautomat nach Anspruch 4, **dadurch gekennzeichnet, dass** die Krafteinheit (26) einen mit einem vorbestimmten Druck beaufschlagbaren Druckzylinder (27) aufweist, der beim Plazieren des Halbleiterchips (1') auf dem Substrat (2) auf den Chipgreifer (16) einwirkt.

6. Montageautomat nach einem der Ansprüche 1 bis 5, **dadurch gekennzeichnet, dass** der Montageautomat ein Die Bonder mit einem Pick and Place System (5) ist, das die Halbleiterchips (1) von einem Wafertisch (4) aufnimmt und an die Flip-Vorrichtung (6) übergibt.

## Claims

1. Automatic assembly machine for the placing of a semiconductor chip (1') as a flipchip on a substrate (2), with a flip device (6) for flipping the semiconductor chip (1'), **characterised in that** the flip device (6) is formed as a parallelogram construction (10, 11, 12, 13), whereby the parallelogram construction (10, 11, 12, 13) consists of a support bracket (10), a first and a second swivel arm (11, 12) and a connecting arm (13), and whereby a chip gripper (16) is arranged on the connecting arm (13), and that a drive system (15, 18, 19) is present for the back and forth movement of the parallelogram construction (10, 11, 12, 13) between a first limit position where the chip gripper (16) accepts the semiconductor chip (1') and a second limit position where the chip gripper (16) places the semiconductor chip (1) on the substrate (2).

2. Automatic assembly machine according to claim 1, **characterised in that** the parallelogram construction (10, 11, 12, 13) is arranged on a slide (9) moveable in vertical direction (8) and that the support bracket (10) can be turned in relation to the slide (9) on a vertical rotational axis (A1).

3. Automatic assembly machine according to claim 1 or 2, **characterised in that** the first limit position and the second limit position of the parallelogram construction (10, 11, 12, 13) are defined mechanically by means of extended positions of the drive system (15, 18, 19).

4. Automatic assembly machine according to one of claims 1 to 3, **characterised in that** a force unit (26) is arranged on the first swivel arm (11) which serves to produce the force to be created between the semiconductor chip (1) and the substrate (2) when placing.

5. Automatic assembly machine according to claim 4, **characterised in that** the force unit (26) has a pressure cylinder (27) to which a predetermined pressure can be applied which acts upon the chip gripper (16) when placing the semiconductor chip (1') on the substrate (2).

6. Automatic assembly machine according to one of claims 1 to 5, **characterised in that** the automatic assembly machine is a die bonder with a pick and place system (5) which picks the semiconductor chips (1) from a wafer table (4) and delivers them to the flip device (6).

## Revendications

1. Robot d'assemblage pour le positionnement d'une puce électronique (1') comme puce électronique à retournement sur un substrat (2), avec un mécanisme de retournement (6) pour le retournement de la puce électronique (1'), **caractérisé en ce que** le mécanisme de retournement (6) est conformé comme une construction à parallélogramme (10, 11, 12, 13), la construction à parallélogramme (10, 11, 12, 13) se composant d'un élément de support (10), d'un premier et d'un second bras pivotants (11, 12) et d'un bras de liaison (13), et un outil de prise (16) étant disposé sur le bras de liaison (13), et **en ce qu'**il existe un système d'entraînement (15, 18, 19) pour le déplacement en va-et-vient de la construction à parallélogramme (10, 11, 12, 13) entre une première position de fin de course dans laquelle l'outil de prise (16) saisit la puce électronique (1') et une seconde position de fin de course dans laquelle l'outil de prise (16) positionne la puce électronique (1) sur le substrat (2).

2. Robot d'assemblage selon la revendication 1, **caractérisé en ce que** la construction à parallélogramme (10, 11, 12, 13) est disposée sur un chariot (9) mobile dans le sens vertical (8) et **en ce que** l'élément de support (10) est rotatif par rapport au chariot (9) autour d'un axe de rotation vertical (A1).

3. Robot d'assemblage selon la revendication 1 ou 2, **caractérisé en ce que** la première position de fin de course et la seconde position de fin de course de la construction à parallélogramme (10, 11, 12, 13) sont définies mécaniquement par des positions d'extension du système d'entraînement (15, 18, 19).

4. Robot d'assemblage selon l'une quelconque des revendications 1 à 3, **caractérisé en ce que** le premier bras pivotant (11) porte une unité motrice (26) qui sert à produire la force à appliquer pour le positionnement entre la puce électronique (1) et le substrat (2).

5. Robot d'assemblage selon la revendication 4, **caractérisé en ce que** l'unité motrice (26) présente un vérin de compression (27) pouvant être soumis à une pression prédéterminée, qui agit lors du positionnement de la puce électronique (1') sur le substrat (2) sur l'outil de prise (16).

6. Robot d'assemblage selon l'une quelconque des revendications 1 à 5, **caractérisé en ce que** le robot d'assemblage est une soudeuse de puces électroniques avec un système de prise et de positionnement (5) qui saisit la puce électronique (1) sur une table de positionnement de wafers (4) et le transfère au mécanisme de retournement (6).
